# EUROPEAN PATENT APPLICATION

(11) **EP 2 484 969 A1**
(43) Date of publication of application: **08.08.2012**
(21) Application number: 09849958.5
(22) Date of filing: 30.09.2009
(51) Int. Cl.: F21V 23/00, F21V 29/00, F21Y 101/02

(54) **LED ENERGY-SAVING LAMP**

(71) Applicant: Huo, Weimin, Shenzhen, Guangdong 518038 (CN)
(72) Inventor: Huo, Weimin, Shenzhen, Guangdong 518038 (CN)
(74) Representative: Van Straaten, Joop
(86) International application number: PCT/CN2009/074337
(87) International publication number: WO 2011/038550

(57) **Abstract**

A light-emitting diode (LED) energy-saving lamp is provided, which includes an energy-saving lamp housing, an LED device, and a power source. The LED device is electrically connected to a metal conducting layer and the energy-saving lamp power source, so as to form a power supply loop of the LED device. When the LED device is an encapsulated LED, the LED is mounted on the metal conducting layer by soldering or welding. When the LED device is a bare LED crystal chip, the LED crystal chip is bonded to the metal conducting layer. An insulating layer is disposed on the other surface of the metal conducting layer bonded to a heat dissipation surface of the LED device, and a heat sink is disposed on the other surface of the insulating layer. A transparent protective adhesive is disposed on the LED crystal chip. A heat conduction efficiency of the LED is effectively improved.

## Description

### BACKGROUND OF THE INVENTION

### Field of Invention

The present invention relates to an illuminating lamp, and more particularly to a light-emitting diode (LED) energy-saving lamp.

### Related Art

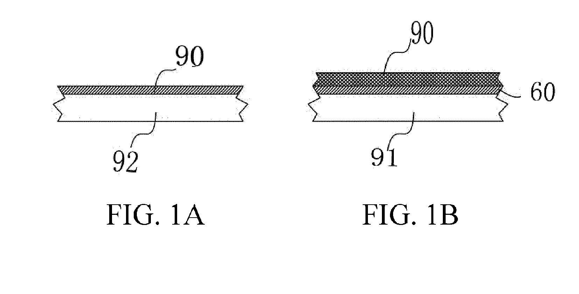

An LED energy-saving lamp has a higher luminous efficiency than a tungsten lamp and an ordinary energy-saving lamp, does not contain mercury as compared with the ordinary energy-saving lamp, and theoretically has a service life several times longer than the ordinary energy-saving lamp, so the LED energy-saving lamp is generally considered as a next-generation electrical light source. However, the light attenuation and service life of an LED crystal chip of a light-emitting device in the LED energy-saving lamp are sensitive to a chip junction temperature during the operation of the chip. A photoelectric conversion efficiency of the existing LED crystal chip is about 25%-35%, and 65%-75% electric energy is converted to heat energy, so a heat dissipation efficiency of the LED crystal chip of the LED energy-saving lamp is crucial to the service life and practicability of the LED energy-saving lamp. An existing LED energy-saving lamp is implemented by mounting an LED device on a circuit board or bonding an LED crystal chip to the circuit board to form a power supply loop. A circuit board shown in FIG. 1A is formed by a metal conducting layer 90 and an insulating substrate 92. Since a heat conduction efficiency of the insulating substrate 92 is low, it is difficult to quickly export the heat generated during the operation of the LED crystal chip, causing that the junction temperature of the LED crystal chip is increased to a degree of affecting the service life of the chip. A circuit board shown in FIG. 1B is formed by a metal conducting layer 90, an insulating layer 60, and a metal substrate 91, and has a high heat conduction efficiency. However, since the thickness of the metal substrate of the circuit board is generally below 2 mm, a heat capacity is low and the circuit board needs to be connected to a metal heat sink in the application to improve the heat dissipation effect. The connection between the bottom surface of the metal substrate and a surface of the metal heat sink may reduce the heat conduction efficiency. Meanwhile, the planar circuit board is hard to meet the requirements for non-planar light-emitting surface of some lamps.

### SUMMARY OF THE INVENTION

In order solve the above problems, the present invention is directed to an LED energy-saving lamp in which an LED device is mounted on a metal conducting layer, and the metal conducting layer is mounted on a metal heat sink through an insulating layer. The metal conducting layer is divided into metal conducting layers independent from each other according to requirements for the formation of a power supply loop of the LED device, so as to form the power supply loop of the LED device.

The objectives of the present invention are achieved through the following technical solution. An LED energy-saving lamp includes an energy-saving lamp housing, an LED device, and a power source.

The LED device 10 is electrically connected to a metal conducting layer 30 and the energy-saving lamp power source 20, so as to form a power supply loop of the LED device.

When the LED device 10 is an encapsulated LED, the LED is mounted on the metal conducting layer 30 through electrical connection.

When the LED device is a bare LED crystal chip, the LED crystal chip is bonded to the metal conducting layer 30.

An insulating layer 50 is disposed on the other surface of the metal conducting layer (30) bonded to a heat dissipation surface of the LED device 10, and a heat sink (40) is disposed on the other surface of the insulating layer 50.

When the LED device is a bare LED crystal chip, a transparent protective adhesive 60 is disposed on the LED crystal chip.

In the LED energy-saving lamp, when the LED device 10 is an encapsulated LED, the connection between the LED and the metal conducting layer 30 is that, a heat export end 111 in the LED bonded with the LED crystal chip is mounted on a sub-metal conducting layer 300, and the sub-metal conducting layer 300 is electrically conducted to a corresponding electrode of the energy-saving lamp power source 20; the other end 112 of the LED is mounted on a sub-metal conducting layer 301, and the sub-metal conducting layer 301 is electrically conducted to the other electrode of the energy-saving lamp power source 20; an insulating layer 60 is disposed between the sub-metal conducting layers 300, 301 and the metal heat sink 40, so as to form a power supply loop for the LED.

In the LED energy-saving lamp, when the LED device 10 is a bare LED crystal chip, the heat dissipation surface 100 of the LED crystal chip is directly bonded to the metal heat sink 30.

If the heat dissipation surface 100 of the LED crystal chip is an electrode, the metal conducting layer 30 bonded with the LED crystal chip is divided into a sub-metal conducting layer 300 and a sub-metal conducting layer 301 independent from each other according to the requirements for the formation of the power supply loop of the LED crystal chip. The LED crystal chip, the metal heat sink 30, and the energy-saving lamp power source 20 form a power supply loop of the LED device.

If the heat dissipation surface 100 of the LED crystal chip is not an electrode, the metal conducting layer 30 bonded with the LED crystal chip is divided into a sub-metal conducting layer 300, a sub-metal conducting layer 301, and a sub-metal conducting layer 302 independent from each other according to the requirements for the formation of the power supply loop of the LED crystal chip. The LED crystal chip, the metal heat sink 30, and the energy-saving lamp power source 20 form a power supply loop of the LED device.

In the LED energy-saving lamp, the heat sink 40 is a desirable heat conductor metal.

In the LED energy-saving lamp, the heat sink 40 is prefabricated into a metal body with a shape required by the LED energy-saving lamp, and the insulating layer 50 and the metal conducting layer 30 are mounted thereon.

In the LED energy-saving lamp, a thickness of the heat sink 40 is greater than 2.5 mm.

In the LED energy-saving lamp, a surface of the metal conducting layer 30 bonded with the LED crystal chip is a reflective surface, and the reflective surface is polished.

In the LED energy-saving lamp, a surface of the metal conducting layer 30 bonded with the LED crystal chip is a reflective surface, and the reflective surface is plated with a desirable light reflective material such as silver.

In the LED energy-saving lamp, the reflective surface is a required surface for design, such as one of a plane, a paraboloidal surface, a conical surface, and a spherical surface, or any combination thereof.

In the LED energy-saving lamp, the insulating layer 50 and the metal conducting layer 30 are mounted on the heat sink 40 prefabricated into a metal body with a shape required by the LED energy-saving lamp, and the transparent protective adhesive 60 is disposed at a light-emitting opening of the heat sink 40 to cover the insulating layer 50, the metal conducting layer 30, and the LED crystal chip.

The present invention effectively solves the problem of low heat conduction efficiency of the LED resulting from that the LED device is mounted on the circuit board or the LED crystal chip is bonded to the circuit board to form the power supply loop in the existing LED energy-saving lamp. The LED energy-saving lamp in which the LED crystal chip is bonded to the metal conducting layer forming the conducting loop of the LED crystal chip, and the metal conducting layer is mounted on the metal conductor heat sink through the insulating layer effectively improves the heat conduction efficiency of the LED.

### BRIEF DESCRIPTION OF THE DRAWINGS

FIG. 1A is a structural view of a circuit board formed by combining an insulating substrate with a metal conducting layer directly;
FIG. 1B is a structural view of a circuit board formed by combining an insulating substrate with a metal conducting layer through an insulating layer;
FIG. 2A is a schematic view of an LED crystal chip bonded to a metal conducting layer;
FIG. 2B is a schematic view of an LED crystal chip bonded to a metal conducting layer;
FIG. 3A is a schematic view of an implementation manner of an LED crystal chip bonded to a metal conducting layer according to the present invention;
FIG. 3B is a schematic view of an implementation manner of an LED mounted on a metal conducting layer according to the present invention;
FIG. 4 is a schematic circuit diagram of an implementation manner of FIG. 3;
FIG. 5 is a schematic view of an implementation manner of an LED crystal chip bonded to a metal conducting layer according to the present invention;
FIG. 6 is a schematic circuit diagram of an implementation manner of FIG. 5;
FIG. 7A is a schematic structural view of a planar reflective surface according to the present invention;
FIG. 7B is a schematic structural view of a shape of a planar reflective surface according to the present invention;
FIG. 8A is a schematic structural view of a non-planar reflective surface according to the present invention;
FIG. 8B is a schematic structural view of a shape of a non-planar reflective surface according to the present invention; and
FIG. 9 is a schematic view of an LED mounted on a metal conducting layer.

### DETAILED DESCRIPTION OF THE INVENTION

In an LED energy-saving lamp of the present invention, an LED device 10 is mounted on a metal conducting layer 30 forming a power supply loop of the LED device, and an insulating layer 60 is disposed between the metal conducting layer 30 and a metal conductor heat sink 40.

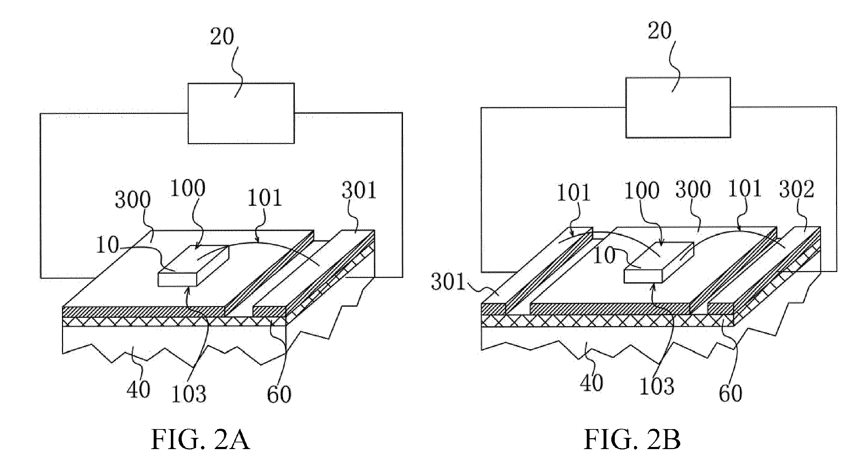

As shown in FIG. 2A, when the LED device 10 is an LED crystal chip, and a heat dissipation surface 103 thereof is an electrode, the metal conducting layer 30 is divided into a sub-metal conducting layer 300 and a sub-metal conducting layer 301 electrically insulated from each other. The heat dissipation surface 103 of the LED crystal chip is bonded to the sub-metal conducting layer 300 of the metal conducting layer 30, and the sub-metal conducting layer 300 is electrically conducted to a corresponding electrode of an energy-saving lamp power source 20. An LED electrode lead 101 is disposed on a light-emitting surface of the LED crystal chip, the electrode lead 101 is connected to the other sub-metal conducting layer 301, and the sub-metal conducting layer 301 is electrically conducted to the other electrode of the energy-saving lamp power source 20. An insulating layer 60 is disposed between the metal heat sink 40 and the sub-metal conducting layers 300, 301, and then a power supply loop is formed for the LED crystal chip.

As shown in FIG. 2B, when the LED device 10 is an LED crystal chip, and a heat dissipation surface 103 thereof is not an electrode, the metal conducting layer 30 is divided into a sub-metal conducting layer 300, a sub-metal conducting layer 301, and a sub-metal conducting layer 302 electrically insulated from each other. The heat dissipation surface 103 of the LED crystal chip is bonded to the sub-metal conducting layer 300, and the sub-metal conducting layer 300 is not electrically conducted to an electrode of the energy-saving lamp power source 20. Two electrodes of the LED crystal chip are respectively provided with an electrode lead 101 and an electrode lead 102, and the electrode lead 101 and the electrode lead 102 are respectively connected to the sub-metal conducting layer 301 and the sub-metal conducting layer 302. The sub-metal conducting layer 301 and the sub-metal conducting layer 302 are respectively electrically conducted to the corresponding electrodes of the energy-saving lamp power source 20. An insulating layer 60 is disposed between the sub-metal conducting layers 300, 301, 302 and the metal heat sink 40, and then a power supply loop is formed for the LED crystal chip.

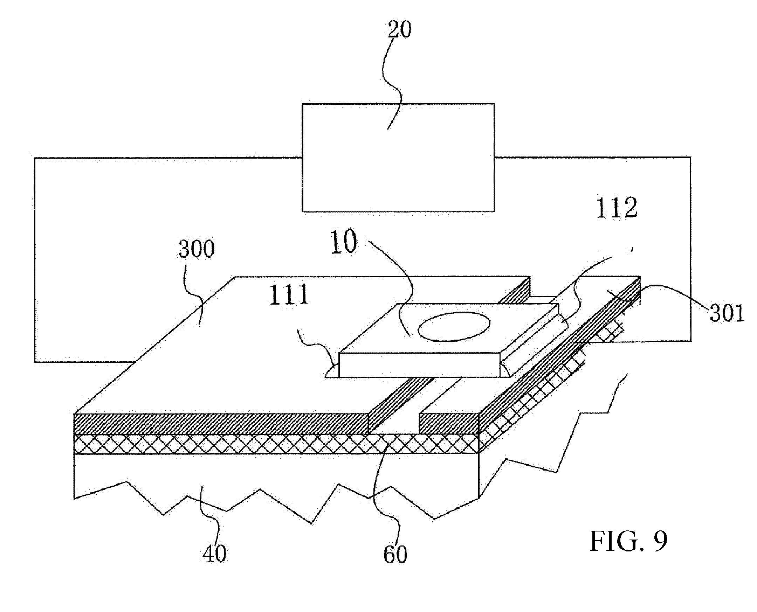

As shown in FIG. 9, when the LED device 10 is an encapsulated LED, a heat dissipation surface of the LED is bonded to the metal conducting layer 30, two electrodes of the LED are respectively provided with an electrode 111 and an electrode 112, and the electrode 111 and the electrode 112 are respectively electrically connected to the sub-metal conducting layer 300 and the sub-metal conducting layer 301. The sub-metal conducting layer 300 and the sub-metal conducting layer 301 are respectively connected to electrodes of the energy-saving lamp power source 20. An insulating layer 60 is disposed between the sub-metal conducting layers 300, 301 and the metal heat sink 40. The electrodes 111 and 112 of the LED may be connected to and fixed on the sub-metal conducting layers 300 and 301 by soldering or welding.

As shown in FIGs. 2A, 2B, and 9, the insulating layer 60 may adopt an insulating layer material for an insulating layer of a common metal substrate circuit board, and the metal conducting layer 30 may adopt a conducting metal foil for a metal conducting layer of a common metal substrate circuit board. A mounting method may adopt the same process as that of pressing the metal conducting layer and the insulating layer on the metal substrate by hot pressing during the production of a common metal substrate circuit board. In a method for manufacturing the metal conducting layer into several independent conducting layers according to requirements for the formation of the power supply loop of the LED device, the same manner as an etching process of the circuit board may be used to etch an entire metal foil into several independent conducting layers according to the requirements.

For the metal substrate circuit board, a standard metal substrate circuit board is used, lines are made through an etching process, and then a finished circuit board is cut according to the required shape and size. A thickness of the metal substrate is standard, which is generally from 1.0 mm to 2.0 mm, and the metal substrate is a standard planar board. In the prior art, when the thickness needs to be increased due to the heat dissipation, a metal heat sink can be merely connected, and then a thermal resistance is increased after the connection, thus reducing a heat dissipation efficiency. When a non-planar light-emitting surface is required, it is also difficult to dissipate heat. In the applied manner, according to the heat dissipation requirements and the requirements for the light-emitting surface, a metal heat sink meeting the requirements for the thickness and shape is first manufactured, and then an insulating layer and a metal conducting layer are pressed or adhered on the surface thereof, and finally, corresponding lines are etched on the metal conducting layer according to the requirements for the power supply loop, thus solving the above problem.

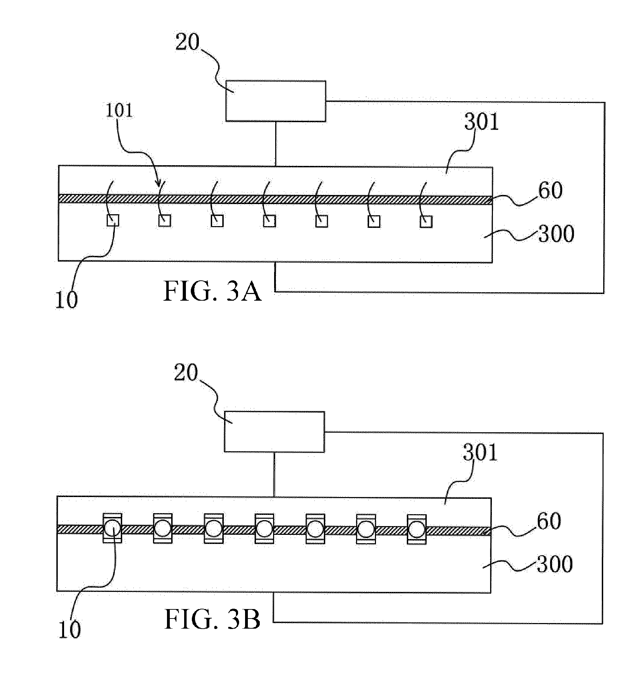

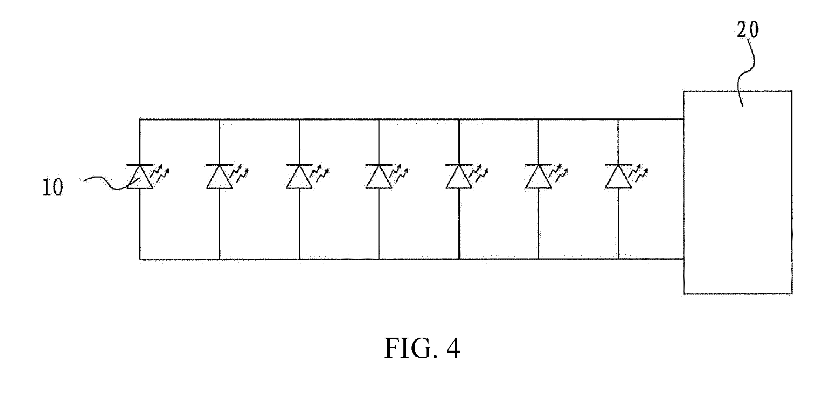

As shown in FIG. 3A, the sub-metal conducting layer 300 is connected to one electrode of the energy-saving lamp power source 20, and multiple LED crystal chips 10 are bonded to the metal conducting layer 300. A light-emitting surface of the LED crystal chip 10 is bonded with an LED electrode lead 101, and the other end of the LED electrode lead 101 is connected to the sub-metal conducting layer 301. The sub-metal conducting layer 301 is connected to the other electrode of the energy-saving lamp power source, and an insulating layer 60 is disposed between the metal conducting layers 300, 301 and the metal heat sink 40, thus forming a parallel power supply loop in the schematic circuit diagram shown in FIG. 4.

As shown in FIG. 3B, the sub-metal conducting layer 300 is connected to one electrode of the energy-saving lamp power source 20, and electrodes at heat export ends of multiple LEDs 10 are mounted on the sub-metal conducting layer 300. Electrodes at the other ends of the LED devices 10 are mounted on the sub-metal conducting layer 301, and the sub-metal conducting layer 301 is connected to the other electrode of the energy-saving lamp power source 20. An insulating layer 60 is disposed between the sub-metal conducting layers 300, 301 and the metal heat sink 40, thus forming a parallel power supply loop in a schematic circuit diagram shown in FIG. 4.

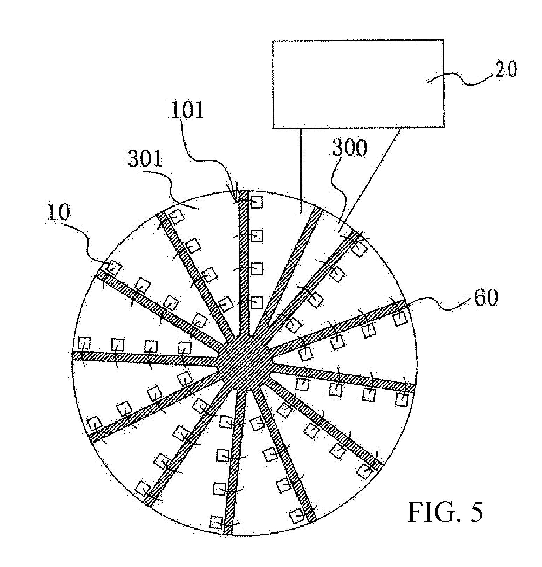

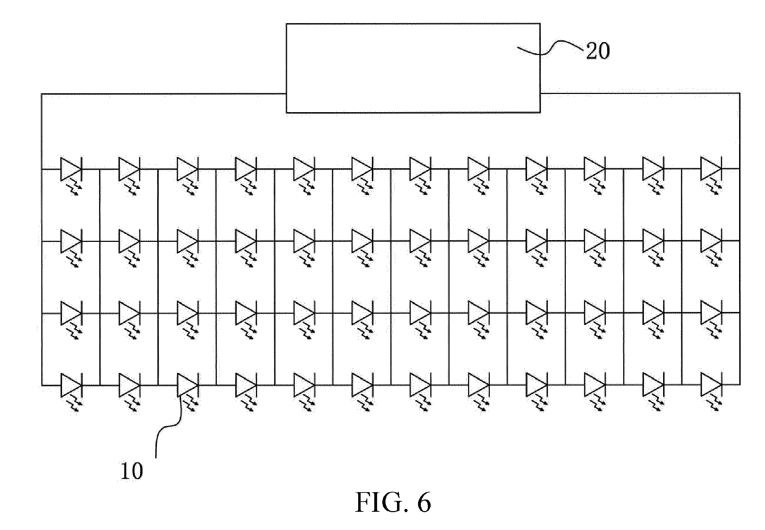

As shown in FIG. 5, the sub-metal conducting layer 300 is connected to one electrode of the energy-saving lamp power source 20, multiple LED crystal chips 10 are bonded to the sub-metal conducting layer 300, a light-emitting surface of the LED crystal chip 10 is connected to an LED electrode lead 101, the other end of the LED electrode lead 101 is connected to an adjacent sub-metal conducting layer 300, and the sub-metal conducting layer 300 is also bonded with multiple LED crystal chips 10; such connection is repeated for many times, the other end of the electrode lead 101 of the LED crystal chip 10 bonded to the sub-metal conducting layer 300 of multiple LED crystal chips 10 is bonded to the sub-metal conducting layer 301, and the sub-metal conducting layer 301 is connected to the other electrode of the energy-saving lamp power source 20. An insulating layer 60 is disposed between the sub-metal conducting layers 300, 301 and the metal heat sink 40, thus forming a serial-parallel power supply loop in the schematic circuit diagram shown in FIG. 6.

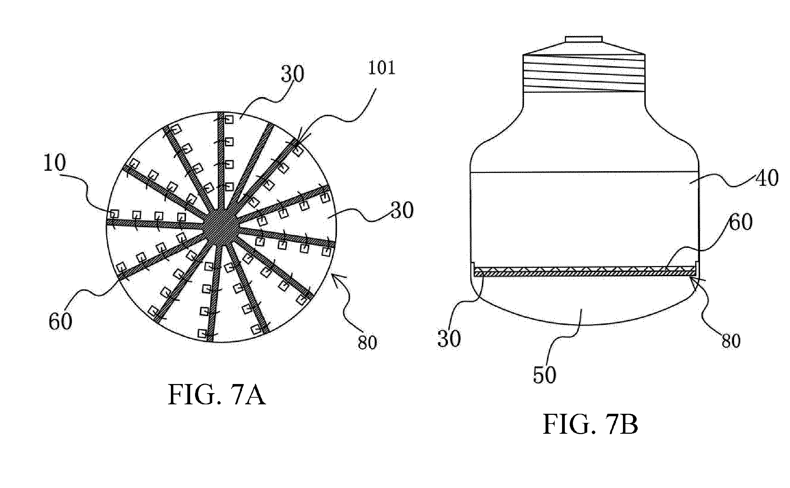

As shown in FIG. 7A, a surface of the metal conducting layer 30 mounted with the LED or bonded with the LED crystal chip forms a reflective surface 80 for reflecting light emitted by the LED or the LED crystal chip. In order to improve the reflection efficiency, the reflective surface 80 may be polished, or plated with a desirable reflective material such as sliver or nickel.

As shown in FIG. 7B, the metal heat sink 40 forms a part of an energy-saving lamp housing, and the metal heat sink 40 exposed to the energy-saving lamp housing can further improve the heat dissipation efficiency. It can be seen that, the metal heat sink 40 may be of various shapes such as a non-planar cylinder, cone, paraboloid, or sphere.

As shown in FIGs. 7A and 7B, the reflective surface 80 formed on the surface of the metal conducting layer 30, the LED device 10, and the insulating layer 60 are covered by a transparent protective adhesive 50. The transparent protective adhesive 50 is a transparent light conductor for exporting light emitted by the LED crystal chip in order to protect the LED crystal chip and the LED electrode lead.

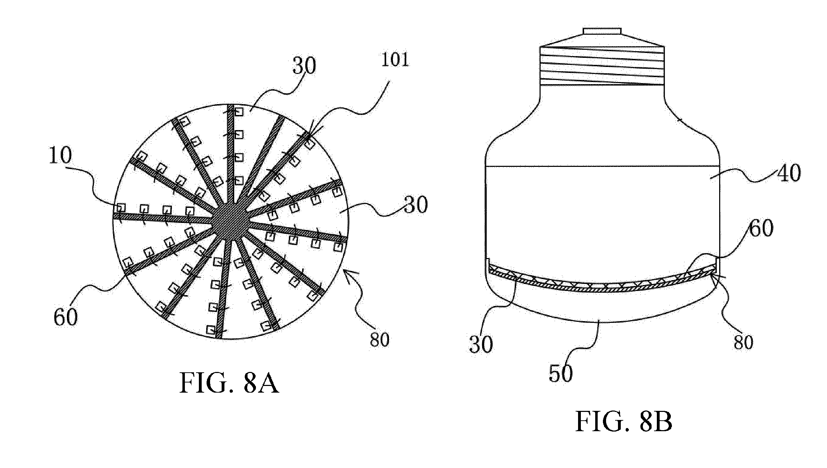

As shown in FIGs. 7A and 7B, the reflective surface of the metal conducting layer 30 is a plane. As shown in FIGs. 8A and 8B, to meet general requirements for the reflective surface of the energy-saving lamp, the reflective surface 80 of the metal conducting layer 30 may be designed into one of a non-planar paraboloidal surface, conical surface, arc surface, and spherical surface, or any combination thereof. To meet the above design requirements, the metal heat sink 30 is prefabricated into a metal body with a shape required by the LED energy-saving lamp, such as a cone, a sphere, a cylinder, a paraboloid, a cuboid, or other shapes.

The devices used by the above units may all adopt common devices.

The present invention has been disclosed through the above embodiments, but the scope of the present invention is not limited thereto. The above components can be replaced by similar or equivalent elements known to persons skilled in the art without departing from the concept of the present invention.

## Claims

1. A light-emitting diode (LED) energy-saving lamp, comprising: an energy-saving lamp housing, an LED device, and a power source, wherein
the LED device (10) is electrically connected to a metal conducting layer (30) and the energy-saving lamp power source (20), so as to form a power supply loop of the LED device;
when the LED device (10) is an encapsulated LED, the LED is mounted on the metal conducting layer (30) through electrical connection;
when the LED device is a bare LED crystal chip, the LED crystal chip is bonded to the metal conducting layer (30);
an insulating layer (50) is disposed on the other surface of the metal conducting layer (30) bonded to a heat dissipation surface of the LED device (10), and a heat sink (40) is disposed on the other surface of the insulating layer (50); and
when the LED device is a bare LED crystal chip, a transparent protective adhesive (60) is disposed on the LED crystal chip.

2. The LED energy-saving lamp according to claim 1, wherein the LED device (10) is an encapsulated LED, the connection between the LED and the metal conducting layer (30) is that, a heat export end (111) in the LED bonded with the LED crystal chip is mounted on a sub-metal conducting layer (300), and the sub-metal conducting layer (300) is electrically conducted to a corresponding electrode of the energy-saving lamp power source (20); the other end (112) of the LED is mounted on a sub-metal conducting layer (301), and the sub-metal conducting layer (301) is electrically conducted to the other electrode of the energy-saving lamp power source (20); an insulating layer (60) is disposed between the sub-metal conducting layers (300, 301) and the metal heat sink (40), so as to form a power supply loop for the LED.

3. The LED energy-saving lamp according to claim 1, wherein the LED device (10) is a bare LED crystal chip, the heat dissipation surface (100) of the LED crystal chip is directly bonded to the metal heat sink (30);
if the heat dissipation surface (100) of the LED crystal chip is an electrode, the metal conducting layer (30) bonded with the LED crystal chip is divided into a sub-metal conducting layer (300) and a sub-metal conducting layer (301) independent from each other according to the requirements for the formation of the power supply loop of the LED crystal chip; the LED crystal chip, the metal heat sink (30), and the energy-saving lamp power source (20) form a power supply loop of the LED device; and
if the heat dissipation surface (100) of the LED crystal chip is not an electrode, the metal conducting layer (30) bonded with the LED crystal chip is divided into a sub-metal conducting layer (300), a sub-metal conducting layer (301), and a sub-metal conducting layer (302) independent from each other according to the requirements for the formation of the power supply loop of the LED crystal chip; the LED crystal chip, the metal heat sink (30), and the energy-saving lamp power source (20) form a power supply loop of the LED device.

4. The LED energy-saving lamp according to claim 1, 2, or 3, wherein the heat sink (40) is a desirable heat conductor metal.

5. The LED energy-saving lamp according to claim 1, 2, or 3, wherein the heat sink (40) is prefabricated into a metal body with a shape required by the LED energy-saving lamp, and the insulating layer (50) and the metal conducting layer (30) are mounted thereon.

6. The LED energy-saving lamp according to claim 1, wherein a thickness of the heat sink (40) is greater than 2.5 mm.

7. The LED energy-saving lamp according to claim 1, 2, or 3, wherein a surface of the metal conducting layer (30) bonded with the LED crystal chip is a reflective surface, and the reflective surface is polished.

8. The LED energy-saving lamp according to claim 1, 2, or 3, wherein a surface of the metal conducting layer (30) bonded with the LED crystal chip is a reflective surface, and the reflective surface is plated with a desirable light reflective material such as sliver.

9. The LED energy-saving lamp according to claim 7, wherein the reflective surface is a required surface for design, such as one of a plane, a paraboloidal surface, a conical surface, and a spherical surface, or any combination thereof.

10. The LED energy-saving lamp according to claim 5, wherein the insulating layer (50) and the metal conducting layer (30) are mounted on the heat sink (40) prefabricated into the metal body with the shape required by the LED energy-saving lamp, and the transparent protective adhesive (60) is disposed at a light-emitting opening of the heat sink (40) to cover the insulating layer (50), the metal conducting layer (30), and the LED crystal chip.
